# DEMANDE DE BREVET EUROPEEN

(11) **EP 1 350 861 A1**
(43) Date de publication de la demande: **08.10.2003**
(21) Numéro de dépôt: 03447062.5
(22) Date de dépôt: 26.03.2003
(51) Int. Cl.: C23C 4/12, C23C 14/34

(54) **Procédé de fabrication et de recharge de cibles pour pulverisation cathodique**

(30) Priorité: 29.03.2002 BE 200200230
(71) Demandeur: Alloys for Technical Applications S.A., 5590 Achene-Ciney (BE)
(72) Inventeur: Clavareau, Guy, 5370 Havelange (BE); Lefevre, Patrick, 7022 Hyon (BE)
(74) Mandataire: Cauchie, Daniel

(57) **Abrégé**

L'invention concerne un procédé de fabrication et de recharge de cibles destinées à la pulvérisation cathodique, constituée d'un ou de plusieurs matériaux conducteurs d'électricité.

L'invention est caractérisée en ce que, tout en refroidissant un support de cible,
a) on provoque, simultanément, la formation d'un arc électrique entre deux fils (15,15') électrodes du ou des matériaux constitutifs de la cible (1) et la fusion résultante de l'extrémité de ces électrodes et,
b) sous l'effet d'un courant gazeux propulseur (12), on pulvérise, sur le support (2), le ou les matériaux en fusion formant une couche de dépôt constitutif de la cible (1).

En outre, l'invention concerne des cibles caractérisées en ce qu'elles comportent uniformément répartis dans leur ensemble, un taux de porosité inférieur ou égal à 5 % et des grains de taille homogène inférieure à 90 µm.

## Description

La présente invention se rapporte d'une manière générale, à un procédé de fabrication et de recharge de cibles destinées à la pulvérisation cathodique.

Plus précisément, l'invention se rapporte à un procédé de fabrication et de recharge de cibles, destinées à la pulvérisation cathodique, constituées d'un ou de plusieurs matériaux conducteurs d'électricité.

En outre, l'invention concerne également un dispositif pour la mise en oeuvre de ce procédé.

Pour obtenir des dépôts de qualité sur des substrats par mise en oeuvre d'un procédé par pulvérisation cathodique magnétron, la qualité des cibles joue un rôle primordial.

Ces cibles doivent être constituées de grains très fins et présenter une structure métallographique idéalement homogène, afin d'éviter des problèmes d'arc et d'obtenir un dépôt d'épaisseur constante durant le procédé.

Par « grain », on entend généralement la plus petite partie constitutive d'un métal polycristallin possédant un réseau cristallin continu.

Actuellement, les cibles destinées à la pulvérisation cathodique sont réalisées à partir d'une matière coulée ou laminée traitée thermiquement ou encore par compression de poudre métallique.

Une fois la cible fabriquée, il est souvent nécessaire de la coller sur un support de refroidissement afin d'éviter des problèmes d'échauffement ou de liquéfaction locale lors de la pulvérisation cathodique magnétron. Le collage de la cible sur le support de refroidissement, habituellement en cuivre, est généralement réalisé par brasage. Cette opération est délicate et difficile car il est important d'avoir un bon contact entre la cible et le support pour obtenir un refroidissement uniforme et optimal. En fait, il existe toujours un danger de surface non brasée qui ferait obstacle à l'évacuation de la chaleur et provoquerait échauffement et décollement.

Dès qu'elles sont usées, les cibles sont décollées du support et mitraillées. Le support peut toutefois être réutilisé pour le collage d'une nouvelle cible après remise en état.

L'ensemble de ces opérations, certaines d'entre elles étant difficiles à mettre en oeuvre, rendent ces procédés de fabrication de cibles de pulvérisation relativement onéreux.

Les cibles obtenues par ces procédés, si elles sont de très faible porosité, sont constituées cependant de grains de taille relativement importante mis en évidence notamment dans le cas particulier de certains métaux tels que l'argent ou le zinc. En conséquence, des cibles de ce type ne permettront pas de fournir un dépôt filmogène réellement homogène et uniforme lors de leur mise en oeuvre dans un procédé de pulvérisation cathodique.

D'autres méthodes de fabrication de cibles de pulvérisation ont été proposées et sont actuellement utilisées de manière courante, à savoir des procédés dits flamme plasma (« plasma spraying ») et fil flamme impliquant la pulvérisation sur un support de matière en fusion et atomisée.

De tels procédés ne sont toutefois pas dénués d'inconvénients. A titre d'exemple, les cibles obtenues par le procédé flamme plasma présentent généralement un taux de porosité relativement important et une structure métallographique peu homogène susceptible de provoquer des problèmes d'arc. En outre, cette méthode ne permet pas une force d'adhérence importante de la matière pulvérisée au support ni une vitesse élevée de projection sur celui-ci.

D'autre part, le procédé fil flamme ne peut être appliqué à la fabrication ni à la recharge de cibles directement sur support cylindrique.

La présente invention a pour but de proposer un procédé de fabrication et de recharge de cible destinée à la pulvérisation du type indiqué précédemment, qui ne présente pas les inconvénients de l'état de la technique et permette la réalisation de cette cible directement sur le support en évitant toute opération de collage ou brasage, la cible obtenue présentant notamment une structure métallographique particulièrement adaptée à la pulvérisation cathodique magnétron.

Pour atteindre ce but, le procédé selon l'invention est caractérisé en ce que, simultanément :
a) on provoque la formation d'un arc électrique entre deux fils électrodes du ou des matériaux constitutifs de la cible et la fusion résultante de l'extrémité de ces électrodes et,
b) sous l'effet d'un courant gazeux propulseur sous pression, on pulvérise, sur un support de cible, le ou les matériaux en fusion formant une couche de dépôt constitutif de la cible.

Un autre objet de l'invention concerne des cibles destinées à la pulvérisation cathodique obtenues selon le procédé de l'invention.

Le procédé ainsi décrit peut être mis en oeuvre avec ou sans refroidissement du support sur lequel le ou les matériaux en fusion sont pulvérisés.

Selon notamment la nature de ces matériaux de départ et en fonction de différents paramètres utilisés tels qu'intensité du courant électrique, épaisseur de la couche de matériaux pulvérisés sur le support ou encore type de surface de ce support, un tel refroidissement peut s'avérer préférable et dans certains cas, indispensable.

Toutefois, le refroidissement du support se révèle davantage nécessaire pour la fabrication d'une cible de configuration plane que pour la fabrication d'une cible de configuration cylindrique.

Les électrodes utilisées pour la mise en oeuvre du procédé selon l'invention, se présentent généralement sous la forme de fils malléables constitués d'un ou de plusieurs matériaux conducteurs d'électricité, habituellement des métaux tels que par exemple zinc, étain, aluminium, titane, argent, nickel, chrome, cobalt, indium.

Si la cible doit être formée de plusieurs matériaux conducteurs d'électricité, les électrodes seront préférentiellement formées chacune des deux métaux dans les proportions envisagées pour la constitution de la cible par exemple des électrodes en un alliage étain/indium, zinc/indium, zinc/étain, zinc/aluminium, nickel/chrome, cobalt/chrome.

Alternativement, ces électrodes peuvent être chacune en un métal différent. Toutefois, cette possibilité sera davantage réservée à la fabrication de cibles dont les proportions des métaux les constituant, par exemple un alliage zinc/étain 90/10 en poids, ne permettent pas l'élaboration d'électrodes suffisamment malléables pour la mise en oeuvre du procédé de l'invention.

Le diamètre de ces fils électrodes est habituellement choisi en fonction de la taille de la cible à fabriquer. De même, il sera adapté à la puissance électrique résultant du courant électrique continu à fournir à ces électrodes. Par ailleurs, ce diamètre sera sélectionné selon le diamètre du grain de cible à obtenir sachant que plus le diamètre des fils électrodes sera petit et plus fine sera la structure de la cible obtenue.

De manière préférentielle mais non limitative, le diamètre des fils électrodes ne sera pas supérieur à 2,5 mm.

D'autre part, la puissance électrique nécessaire à la formation de l'arc électrique et à la fusion résultante des électrodes, dépend notamment de leur écartement, généralement de 2 à 5 mm et de leur nature étant entendu que plus le point de fusion de ces fils est bas et plus la puissance requise pour leur fusion est faible.

A titre d'exemple, la puissance électrique à utiliser sera de l'ordre de 25 KW pour l'argent et de 5 KW pour l'étain.

Le support, destiné à recevoir la cible, est constitué d'une plaque en matériau conducteur d'électricité habituellement le cuivre ou l'acier inoxydable, cette plaque étant configurée de manière à pouvoir être utilisée dans un procédé de pulvérisation cathodique magnétron. En outre, la plaque de support en question, généralement de forme plane peut, selon les nécessités, adopter d'autres formes plus généralement la forme cylindrique.

Par ailleurs, la couche de dépôt constitutif de la cible sera fixée au support par sa face supérieure préalablement aménagée de manière appropriée. Généralement, cette cible sera maintenue sur le support par un effet d'ancrage, c'est-à-dire par adhérence mécanique du ou des matériaux atomisés déposés par pulvérisation sur celui-ci. De manière à accroître cette adhérence, le support présente habituellement une certaine rugosité obtenue par des techniques connues de grenage telle que sablage.

Toutefois si une diffusion est nécessaire entre le support et la couche de dépôt, celle-ci sera provoquée par une couche de diffusion fixée au support telle qu'une couche de zinc/indium ou de nickel/aluminium et par un traitement thermique approprié de sorte que le maintien au support sera obtenu par adhérence à la fois mécanique et chimique.

Quant au gaz propulseur, il s'agit généralement d'un gaz neutre tel que par exemple l'hélium ou l'argon ou préférentiellement l'azote.

Toutefois, et selon les nécessités, ce gaz neutre peut contenir une fraction en volume d'un gaz réactif.

A titre d'exemple, lorsque la cible doit contenir une certaine proportion en poids d'un oxyde du ou d'un métal constitutif de celle-ci, le gaz neutre propulseur contiendra une fraction adéquate d'un volume d'oxygène, habituellement jusqu'à 10 % en volume.

La cible fabriquée selon le procédé de l'invention résulte en fait d'un dépôt provoqué par un balayage du jet de pulvérisation sur le support de manière équidistante de celui-ci et à une vitesse relative de l'ordre du mètre/seconde par rapport à celui-ci.

L'accumulation de chaleur étant toutefois importante lors de la formation de ce dépôt de pulvérisation, le refroidissement du support de cible peut, dans certains cas, s'avérer indispensable pour éviter sa déformation. Ce refroidissement s'opère habituellement par circulation d'un fluide qui peut être gazeux ou préférentiellement liquide tel que par exemple un liquide réfrigérant ou plus généralement par circulation d'eau.

Toutefois, plus l'épaisseur du dépôt s'accroît et plus le refroidissement au niveau de la surface de celui-ci s'avère difficile jusqu'à devenir inefficace. A ce stade, la pulvérisation sur le support doit être momentanément suspendue pour permettre une uniformisation de la chaleur au sein du dépôt à partir de sa surface.

Le procédé de l'invention, qui peut être mis en oeuvre dans une enceinte maintenue sous atmosphère normale (air) ou de composition contrôlée, permet d'obtenir jusqu'à 25 kg de dépôt par heure provenant des électrodes ainsi que la formation de cibles d'épaisseur pouvant atteindre jusqu'à 30 mm d'épaisseur lors d'une seule opération de mise en oeuvre, c'est-à-dire avant d'envisager la nécessité d'arrêter la pulvérisation pour permettre un refroidissement adéquat.

Selon les besoins, des cibles d'épaisseur supérieure à 30 mm peuvent être réalisées par mise en oeuvre du procédé de l'invention toutefois en plusieurs opérations, un dépôt d'une épaisseur de 30 mm étant généralement considéré comme maximal en une seule opération.

L'invention propose également un dispositif pour la mise en oeuvre du procédé ci-dessus, dispositif comprenant :
a) une tête d'un pistolet de pulvérisation par arc électrique comportant un boîtier dans lequel est aménagée une chambre de pulvérisation ouverte extérieurement à sa base et dans laquelle débouche d'une part deux fils électrodes constitués d'un ou de plusieurs matériaux conducteurs d'électricité et dont les extrémités convergentes sont suffisamment rapprochées pour pouvoir provoquer la formation d'un arc électrique, et d'autre part une cavité d'amenée d'un courant gazeux sous pression, et indépendamment,
b) un support de cible comprenant une face supérieure et une face inférieure, la face supérieure étant configurée pour recevoir et maintenir par adhérence une couche de dépôt constitutif de la cible.

L'adhérence, nécessaire au maintien de la couche de dépôt sur le support peut être d'origine mécanique, auquel cas le support présente habituellement une certaine rugosité ou d'origine à la fois mécanique et chimique, auquel cas, une couche de diffusion est fixée au support et un traitement thermique approprié est appliqué.

D'autre part, ce support peut être conçu de telle manière que sa face inférieure puisse être, le cas échéant, en contact avec un fluide de refroidissement.

Le procédé et le dispositif pour sa mise en oeuvre ainsi décrits présentent de nombreux avantages par rapport à l'état de la technique.

Ainsi, ce procédé permet une force d'accrochage de la cible au support supérieure à la force obtenue avec des procédés de l'art antérieur, par exemple une force d'accrochage de 2 à 5 fois supérieures au procédé fil flamme. D'autre part, le procédé de l'invention est d'un coût énergétique faible tandis qu'il peut être mis en oeuvre à partir de tout fil disponible, conducteur d'électricité.

Les différents paramètres inhérents au procédé de l'invention tels qu'intensité du courant électrique, vitesse de propagation du gaz propulseur, diamètre des fils électrodes, matériaux à déposer sont fixés avant la mise en oeuvre de ce procédé et ne sont pas modifiés au cours de celui-ci.

Il en résulte, par conséquent, à la fois une excellente homogénéité de la taille des grains de cible et une uniformité très importante de la répartition de ces grains dans de grands volumes de couche de dépôt au contraire d'un procédé de fabrication par coulée où l'uniformité en question est beaucoup plus difficile à obtenir en raison de gradients de température.

Par conséquent, il est possible, au moyen du procédé de l'invention, de fabriquer et de recharger des cibles de pulvérisation cathodique qui présentent, outre un taux de porosité très réduit, des grains de taille extrêmement faible procurant une structure métallographique particulièrement homogène et uniforme. Habituellement, des taux de porosité inférieur ou égal à 5 % et des grains de taille inférieure à 90 µm peuvent être obtenus, et de manière particulièrement avantageuse des taux de porosité compris entre 2 et 5 % et des grains de taille comprise entre 10 et 90 µm.

En conséquence, l'invention se rapporte également à des cibles constituées d'un ou de plusieurs matériaux conducteurs d'électricité et destinées à la pulvérisation cathodique, caractérisées en ce qu'elles comportent, uniformément répartis dans leur ensemble, un taux de porosité inférieur ou égal à 5 % et des grains de taille homogène inférieure à 90 µm en particulier un taux de porosité compris entre 2 et 5 % et des grains de taille homogène comprise entre 10 et 90 µm.

A titre d'exemples non limitatifs, des cibles selon l'invention peuvent être constituées d'un ou de plusieurs matériaux conducteurs d'électricité, choisis parmi le zinc, l'étain, l'aluminium, le titane, l'argent, le nickel, le chrome, le cobalt et l'indium. En particulier des cibles selon l'invention peuvent être constituées d'étain ou d'alliages d'étain tel qu'étain/indium ; de zinc ou d'alliages de zinc tels que zinc/aluminium ou zinc/étain ou encore de chrome ou d'alliages de chrome tels que chrome/nickel ou chrome/cobalt.

Un autre objet de l'invention concerne également un ensemble destiné à la pulvérisation cathodique, caractérisé en ce qu'il comprend une cible selon l'invention, telle que définie précédemment, fixée et maintenue sur un support de cible par adhérence mécanique ou par adhérence mécanique et chimique.

En outre, un autre objet de l'invention concerne l'utilisation de cibles selon l'invention, telles que définies précédemment, pour la formation d'un dépôt filmogène sur un substrat par mise en oeuvre d'un procédé de pulvérisation cathodique.

De même, l'invention se rapporte à un dépôt filmogène sur un substrat, caractérisé en ce qu'il est obtenu par mise en oeuvre d'un procédé de pulvérisation cathodique au départ d'une cible selon l'invention, telle que définie précédemment.

L'invention sera mieux comprise et d'autres buts, caractéristiques et avantages de celle-ci apparaîtront plus clairement au cours de la description explicative qui va suivre faite en référence aux dessins schématiques annexés donnés uniquement à titre d'exemple illustrant des modes de réalisation de l'invention et dans lesquels :
- la figure 1 est une vue schématique en coupe d'un dispositif pour la fabrication et la recharge de cibles de pulvérisation selon l'invention,
- la figure 2 est une représentation de la structure métallographique d'une cible plane de Zn/Sn (50/50) obtenue selon l'invention,
- la figure 3 est une représentation d'un examen microsonde de la structure de la cible de la figure 2.

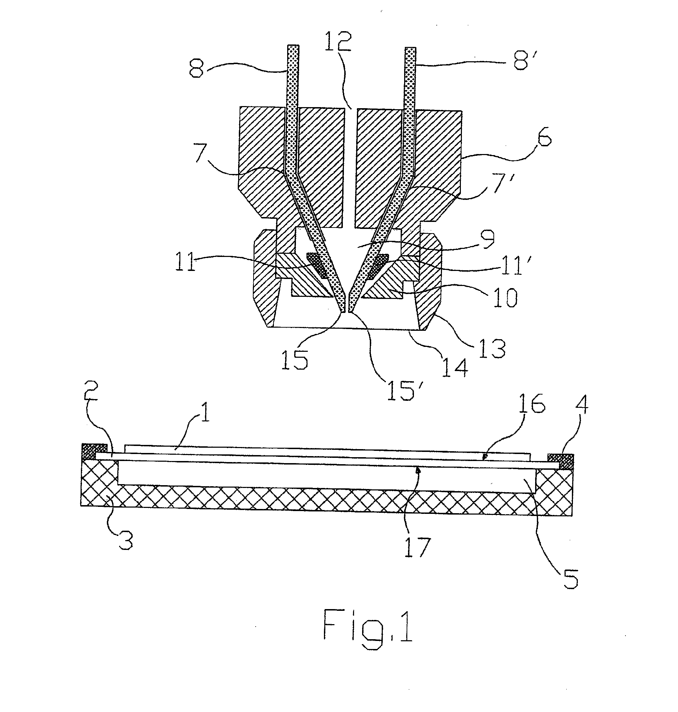

Sur cette figure 1, on a représenté en 1, une cible de pulvérisation fixée sur une plaque 2 formant support maintenue sur un refroidisseur 3 au moyen d'un clamp 4.

Une cuvette 5 creusée à partir de la partie supérieure du refroidisseur 3 sert à contenir un liquide habituellement l'eau, destiné au refroidissement de ladite plaque 2.

La figure 1 montre également la tête d'un pistolet de pulvérisation par arc électrique, généralement circulaire, formé d'un boîtier extérieur 6 percé, à partir de sa partie supérieure, de deux cavités contenant les tubes creux 7 et 7' en un matériau conducteur d'électricité tel que le bronze dans lesquels coulissent les fils 8 et 8' formant électrodes, en contact avec les tubes 7 et 7' respectivement.

Ces tubes 7 et 7' ainsi que les électrodes 8 et 8' débouchent dans une chambre 9, par sa partie supérieure fermée, aménagée dans le boîtier 6.

D'autre part, la partie inférieure 10 du boîtier 6 est configurée de manière à donner à la partie inférieure de la chambre 9 une forme tronconique ouverte extérieurement à sa base.

Cette chambre 9 contient également les guides directionnels 11 et 11' des électrodes 8 et 8'. En outre, une troisième cavité 12 d'amenée de gaz sous pression, creusée axialement dans le boîtier 6, débouche également dans la chambre 9, à sa partie supérieure.

On voit également sur la figure 1 que le nez 13, solidaire du boîtier 6 et de forme habituellement annulaire est pourvu d'un régulateur de projection 14.

Conformément à l'invention, un dérouleur des fils 8 et 8', non représenté, alimente les tubes 7 et 7' respectivement et amène ces fils à coulisser à l'intérieur de ces tubes en direction de la chambre 9 tandis que les guides 11 et 11' maintiennent la convergence l'une vers l'autre des extrémités 15 et 15' de ces fils et assure un réglage approprié de leur écartement.

Les tubes 7 et 7' sous tension électrique, assurent la mise sous tension électrique continue respectivement des fils 8 et 8' en contact permanent avec ceux-ci avec, comme résultante, la formation d'un arc électrique entre les extrémités métalliques 15 et 15' et la fusion de celles-ci dans la zone de température élevée crée par l'arc.

Simultanément, un courant gazeux sous pression, par exemple un courant d'azote, est propulsé dans le conduit 12 jusqu'à pénétrer dans la chambre 9 où il provoque l'atomisation du métal en fusion et la pulvérisation des particules métalliques sur la face supérieure 16 de la plaque support 2, tandis que le refroidissement de cette plaque est assuré, via sa face inférieure 17 par un courant d'eau circulant dans la cuvette 5 du refroidisseur 3.

Le dépôt devant être réparti de manière uniforme sur la plaque support 2 pour constituer une cible d'épaisseur constante, la tête du pistolet de pulvérisation est affectée d'un mouvement de translation à vitesse constante, parallèle à la plaque support plane 2 et équidistant de celle-ci de manière à assurer une pulvérisation par balayage, sur la surface de la cible.

D'autre part, l'intensité du jet et la zone de dispersion de particules métalliques issu de la chambre 9 peuvent être modulés, si nécessaire, au moyen du régulateur 14.

Les cible 1 et plaque de support 2 représentées à la figure 1 sont de forme plane.

Toutefois, lorsque la plaque de support et, par voie de conséquence la cible sont de forme cylindrique, la tête du pistolet de pulvérisation est affectée d'un mouvement de va et vient au-dessus de la plaque support maintenue en rotation à vitesse constante autour de son axe longitudinal tandis que, s'il s'avère nécessaire, le refroidissement du cylindre support est assuré par une circulation d'eau à l'intérieur de celui-ci.

Le procédé de l'invention ainsi décrit offre la possibilité de procéder au dépôt de nombreux matériaux conducteurs d'électricité.

De plus, il permet d'obtenir des cibles de structure métallographique très fine et homogène et une porosité quasi inexistante qui convient bien au procédé de pulvérisation cathodique.

Au surplus, l'application du matériau directement sur le support de refroidissement crée un excellent contact entre ce support et la cible, contact dont il est possible de contrôler visuellement la qualité durant le dépôt.

Enfin, le procédé de l'invention offre la possibilité de recharger les cibles après leur utilisation, ce qui permet d'éviter la nécessité de recoller la cible sur une plaque support.

Les exemples non-limitatifs suivants illustrent le procédé de l'invention appliqué à la fabrication de cibles selon l'invention :

### EXEMPLE 1

### Fabrication d'une cible plane de Zn/Sn (50/50)

On a fabriqué une cible métallique plane de Zn/Sn (50/50) selon le procédé de l'invention, par arc électrique entre deux électrodes de Zn/Sn (50/50) impliquant l'atomisation et la projection du métal en fusion sur une plaque de cuivre de 100 x 300 x 2 mm traitée mécaniquement par sablage.

Les paramètres suivants ont été utilisés :
- vitesse de projection sur le support : 250m/s
- distance plaque support/tête du pistolet : 13cm
- puissance électrique : 5KW
(tension : 25v, intensité 200 A)
- pression du gaz (azote) : 2,5 bar
- vitesse de dépôt : 20kg/h

Le refroidissement de la plaque support plane s'est fait par attache de celle-ci sur un refroidisseur dans lequel circule l'eau.

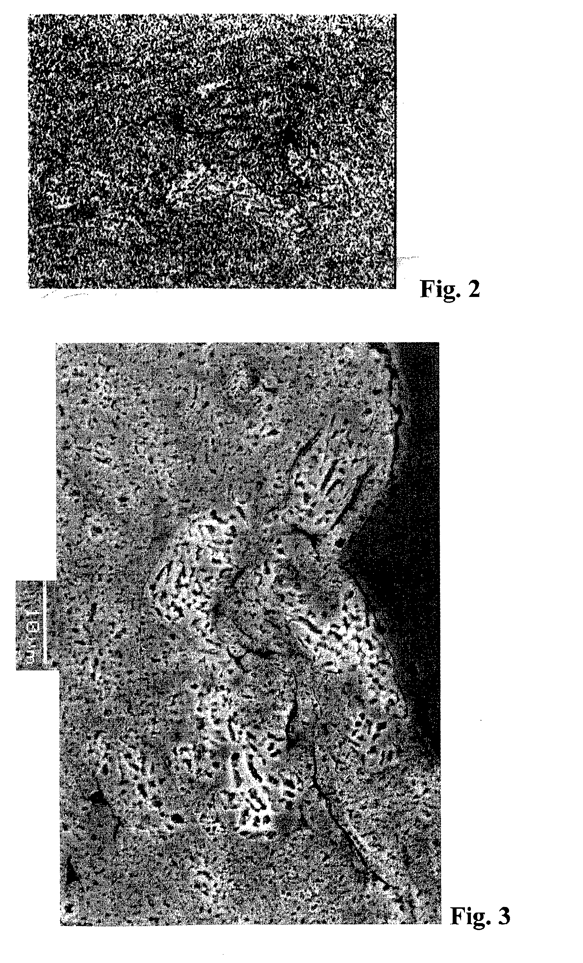

La structure métallographique du dépôt ainsi obtenu est représentée à la figure 2 (grossissement : 1000 fois) alors que la figure 3 représente un examen microsonde de ce dépôt.

Ces figures montrent que la cible obtenue présente une structure métallographique très fine, homogène et de faible porosité répartie uniformément. D'autre part, le taux de porosité mis en évidence, ne dépasse pas 5 % et la taille des grains, répartis uniformément, n'excède pas 90 µm au regard de l'unité de longueur mentionnée à la figure 3, à savoir 10 µm.

Une cible destinée à la méthode de pulvérisation cathodique sur substrat présentant une telle métallographie apportera les avantages suivants lors de la mise en oeuvre de ce procédé :
- homogénéité du dépôt car une taille de grain faible et homogène sur l'ensemble de la cible améliore l'uniformité de ce dépôt.
- meilleur refroidissement car une structure dense permet une meilleure évacuation de la chaleur.
- une durée de vie allongée car la densité obtenue est proche de 100 %.

### EXEMPLE 2

### Fabrication d'une cible cylindrique de Zn/Sn (50/50)

On a fabriqué une cible métallique d'une épaisseur de 10 mm de Zn/Sn (50/50) selon le procédé de l'invention, par arc électrique entre deux électrodes de Zn/Sn (50/50) impliquant l'atomisation et la projection du métal en fusion sur un tube support en cuivre d'un diamètre de 127 mm et d'une longueur de 500 mm.

A cet effet, on a utilisé les mêmes paramètres qu'à l'Exemple 1 mais sans effectuer de refroidissement de ce tube support.

## Revendications

1. Procédé de fabrication et de recharge de cible destinée à la pulvérisation cathodique, constituée d'un ou de plusieurs matériaux conducteurs d'électricité, **caractérisé en ce que** simultanément :
a) on provoque, la formation d'un arc électrique entre deux fils électrodes du ou des matériaux constitutifs de la cible et la fusion résultante de l'extrémité de ces électrodes et,
b) sous l'effet d'un courant gazeux propulseur sous pression, on pulvérise, sur un support de cible, le ou les matériaux en fusion formant une couche de dépôt constitutif de la cible.

2. Procédé selon la revendication 1, **caractérisé en ce que** le support de cible est refroidi.

3. Procédé selon la revendication 2, **caractérisé en ce que** le support de cible est refroidi par circulation d'un fluide.

4. Procédé selon la revendication 3, **caractérisé en ce que** le support de cible est refroidi par circulation d'eau.

5. Procédé selon une des revendications 1 à 4, **caractérisé en ce que** le courant gazeux propulseur est formé d'un gaz neutre.

6. Procédé selon la revendication 5, **caractérisé en ce que** le gaz neutre contient une fraction en volume d'un gaz réactif.

7. Procédé selon une des revendications 1 à 6, **caractérisé en ce que** les fils électrodes sont constitués d'un ou de plusieurs matériaux conducteurs d'électricité choisis parmi le zinc, l'étain, l'aluminium, le titane, l'argent, le nickel, le chrome, le cobalt et l'indium.

8. Procédé selon une des revendications 1 à 7, **caractérisé en ce que** les fils électrodes sont constitués d'un alliage choisi parmi un alliage étain/indium, zinc/indium, zinc/étain, zinc/aluminium, nickel/chrome et cobalt/chrome.

9. Procédé selon une des revendications 1 à 8, **caractérisé en ce que** la couche de dépôt est maintenue sur le support par adhérence mécanique ou par adhérence mécanique et chimique.

10. Dispositif pour la mise en oeuvre du procédé selon une des revendications 1 à 9, **caractérisé en ce qu'**il comprend :
a) une tête d'un pistolet de pulvérisation par arc électrique comportant un boîtier dans lequel est aménagée une chambre de pulvérisation ouverte extérieurement à sa base et dans laquelle débouche d'une part deux fils électrodes constitués d'un ou de plusieurs matériaux conducteurs d'électricité et dont les extrémités convergentes sont suffisamment rapprochées pour pouvoir provoquer la formation d'un arc électrique et leur fusion résultante, et d'autre part une cavité d'amenée d'un courant gazeux sous pression, et indépendamment,
b) un support de cible comprenant une face supérieure et une face inférieure, la face supérieure étant configurée pour recevoir et maintenir par adhérence une couche de dépôt constitutif de la cible.

11. Dispositif selon la revendication 10 ou 11, **caractérisé en ce que** la face inférieure est en contact avec un fluide de refroidissement.

12. Cible constituée d'un ou de plusieurs matériaux conducteurs d'électricité et destinée à la pulvérisation cathodique, **caractérisée en ce qu'**elle comporte, répartis uniformément dans son ensemble, un taux de porosité inférieur ou égal à 5 % et des grains de taille homogène inférieure à 90 µm.

13. Cible selon la revendication 12, **caractérisée en ce qu'**elle comporte un taux de porosité compris entre 2 et 5 %.

14. Cible selon la revendication 12 ou 13, **caractérisée en ce qu'**elle comporte des grains de taille comprise entre 10 et 90 µm.

15. Cible selon une des revendications 12 à 14, **caractérisée en ce qu'**elle est constituée d'un ou de plusieurs matériaux conducteurs d'électricité choisis parmi le zinc, l'étain, l'aluminium, le titane, l'argent, le nickel, le chrome, le cobalt ou l'indium.

16. Cible selon la revendication 15, **caractérisée en ce qu'**elle est constituée d'étain ou d'alliages d'étain ; de zinc ou d'alliages de zinc ou de chrome ou d'alliages de chrome.

17. Ensemble destiné à la pulvérisation cathodique, **caractérisé en ce qu'**il comprend une cible selon une des revendications 12 à 16 fixée et maintenue sur un support de cible par adhérence mécanique ou par adhérence mécanique et chimique.

18. Utilisation d'une cible selon une des revendications 12 à 16 pour la formation d'un dépôt filmogène sur un substrat par mise en oeuvre d'un procédé de pulvérisation cathodique.

19. Dépôt filmogène sur un substrat **caractérisé en ce qu'**il est obtenu par mise en oeuvre d'un procédé de pulvérisation cathodique au départ d'une cible selon une des revendications 12 à 16.
